Europäisches Patentamt

European Patent Office

Office européen des brevets

(19)

(11) Veröffentlichungsnummer: **0 268 790 B1**

# (12) EUROPÄISCHE PATENTSCHRIFT

(45) Veröffentlichungstag der Patentschrift: **15.04.92**

(21) Anmeldenummer: **87114631.2**

(22) Anmeldetag: **07.10.87**

(51) Int. Cl.⁵: **B41N 1/08**, C25F 3/04,
C25D 11/04, C25D 11/16,
C23F 1/02

(54) **Verfahren zur abtragenden Modifizierung von mehrstufig aufgerauhten Trägermaterialien aus Aluminium oder dessen Legierungen und deren Verwendung bei der Herstellung von Offsetdruckplatten.**

(30) Priorität: **17.10.86 DE 3635303**

(43) Veröffentlichungstag der Anmeldung:
**01.06.88 Patentblatt 88/22**

(45) Bekanntmachung des Hinweises auf die Patenterteilung:
**15.04.92 Patentblatt 92/16**

(84) Benannte Vertragsstaaten:
**DE FR GB**

(56) Entgegenhaltungen:
**EP-A- 0 097 301**
**DE-A- 3 305 067**
**FR-A- 2 336 261**

(73) Patentinhaber: **HOECHST AKTIENGESELL-SCHAFT**
**Postfach 80 03 20**
**W-6230 Frankfurt am Main 80(DE)**

(72) Erfinder: **Mohr, Dieter, Dr., Dipl.-Chem.**
**Mainstrasse 5**
**W-6229 Schlangenbad 5(DE)**
Erfinder: **Pliefke, Engelbert, Dr., Dipl.-Chem.**
**Drususstrasse 52**
**W-6200 Wiesbaden(DE)**

EP 0 268 790 B1

**Beschreibung**

Die Erfindung betrifft ein Verfahren zur elektrochemischen Modifizierung von in einem Mehrstufenprozeß aufgerauhten Druckplatten-Trägermaterialien auf der Basis von Aluminium oder seinen Legierungen nach der ersten mechanischen und/oder der zweiten elektrochemischen Aufrauhstufe und die Verwendung des so modifizierten Materials bei der Herstellung von Offsetdruckplatten.

Trägermaterialien für Offsetdruckplatten werden entweder vom Verbraucher direkt oder vom Hersteller vorbeschichteter Druckplatten ein- oder beidseitig mit einer strahlungs(licht)empfindlichen Schicht (Kopier- oder Reproduktionsschicht) versehen, mit deren Hilfe ein druckendes Bild (Druckform) auf photomechanischem Wege erzeugt wird. Nach Herstellung der Druckform trägt der Schichtträger die druckenden Bildstellen und bildet zugleich an den bildfreien Stellen (Nichtbildstellen) den hydrophilen Bilduntergrund für den lithographischen Druckvorgang.

An einen Schichtträger für solches strahlungsempfindliches Material zum Herstellen von lithographischen Platten sind u. a. folgende Anforderungen zu stellen:

- Die nach der Bestrahlung relativ löslicheren Teile der strahlungsempfindlichen Schicht müssen durch eine Entwicklung leicht zur Erzeugung der hydrophilen Nichtbildstellen rückstandsfrei vom Träger zu entfernen sein.
- Der in den Nichtbildstellen freigelegte Träger muß eine große Affinität zu Wasser besitzen, d. h. stark hydrophil sein, um beim lithographischen Druckvorgang schnell und dauerhaft Wasser aufzunehmen und gegenüber der fetten Druckfarbe ausreichend abstoßend zu wirken.
- Die Haftung der lichtempfindlichen Schicht vor bzw. der druckenden Teile der Schicht nach der Belichtung muß in einem ausreichenden Maß gegeben sein.
- Das Trägermaterial soll eine gute mechanische Beständigkeit z. B. gegen Abrieb und eine gute chemische Resistenz, insbesondere gegenüber alkalischen Medien, besitzen.
- Der Wasserbedarf beim Drucken soll möglichst gering sein, um beispielsweise eine Überfeuchtung des Papiers zu verhindern, da es sonst zu "Passerschwierigkeiten" beim Mehrfarbendrucken (d. h. der zweite oder dritte Farbton können nicht mehr deckungsgleich auf den ersten Farbton gedruckt werden) oder zu Papierbahnrissen beim Rollenoffset kommen kann.

Zur Erfüllung einiger dieser Anforderungen werden die in der Praxis üblicherweise eingesetzten Trägermaterialien aus Aluminium zunächst mechanisch, chemisch und/oder elektrochemisch aufgerauht, wonach sich auch noch eine anodische Oxidation der aufgerauhten Aluminiumoberfläche anschließen kann. Insbesondere elektrochemisch aufgerauhte Aluminiumoberflächen mit ihrer sehr feinkörnigen Struktur bewirken als Grenzschicht zwischen dem Trägermaterial und der strahlungsempfindlichen Schicht von Druckplatten bei den daraus herstellbaren Druckformen praxisgerechte Ergebnisse, die bereits die meisten der Anforderungen erfüllen. Der Wasserbedarf beim Drucken ist jedoch bei den nach bekannten Verfahren aufgerauhten und gegebenenfalls anodisch oxidierten Trägermaterialien oftmals noch zu hoch. Es sind deshalb auch bereits Modifizierungen dieser Verfahren beschrieben worden, die insbesondere nach der Aufrauhstufe zum Einsatz kommen können.

Aus der DE-A 30 09 103 (= ZA-A 81/1545) ist eine abtragende Modifizierung von elektrochemisch aufgerauhten Druckplatten-Trägermaterialien aus Aluminium bekannt, bei der ein Flächenabtrag von 0,4 bis 3,0 g/m$^2$ unter der Einwirkung von wäßrig-alkalischer Lösung eines pH-Werts von mehr als 11 stattfindet. Aus derartig modifizierten und gegebenenfalls anodisch oxidierten Trägermaterialien hergestellte Druckplatten sollen einen geringeren Feuchtwasserverbrauch und eine geringere Adsorptivität zeigen.

In dem Herstellungsverfahren für Druckplatten-Trägerma-terialien aus Aluminium gemäß der DE-A 25 57 222 (inhaltlich ähnlich ist die US-A 3 935 080) wird das Trägermaterial zwischen der Stufe einer elektrochemischen Aufrauhung in wäßriger Salzsäure und der Stufe einer anodischen Oxidation in wäßriger Schwefelsäure noch kathodisch in wäßriger Schwefelsäure modifiziert (gereinigt). Das Verfahren soll in erster Linie für die kontinuierliche Verfahrensführung geeignet sein und zu einer sehr sauberen Oberfläche führen.

Eine kathodische Behandlung ist auch für andere Verfahrensweisen aus dem Stand der Technik bekannt.

Eine kathodische Kontaktierung von Aluminiumträgern wird nach der DE-B 24 20 704 (= US-A 3 865 700) bei deren anodischer Oxidation in wäßriger Schwefelsäure eingesetzt, um die Verwendung von den üblicherweise vorhandenen Kontaktrollen zu vermeiden.

Aus der DE-C 25 37 724 (= GB-A 1 532 303) ist ein einstufiges Aufrauhverfahren ohne nachfolgende abtragende Modifizierung der Oberfläche bekannt, bei dem Druckplatten-Trägermaterialien aus Aluminium in bewegten wäßrigen Salzlösungen einer Konzentration von mindestens 200 g/l an Salz, eines pH-Werts von 5 bis 8 und bei einer Temperatur von weniger als 60° C elektrochemisch behandelt werden. Als Salze werden Alkali-, Erdalkali-oder Ammoniumsalze von Halogenwasserstoffsäuren oder Sauerstoffsäuren des Stickstoffs oder von Halogenen eingesetzt. In einer Verfahrensvariante (zu Oberflächen des Typs A) kann das Aluminium in kathodischer Schaltung mit Gleichstrom von 70 bis 150 A/dm$^2$ während 30 bis 60 sec aufgerauht werden, wobei eine silbrig mattglänzende Oberfläche entsteht; in dieser Variante werden ausschließlich Alkalisalze eingesetzt. Auch in der DE-C 25 37 725 (= GB-A 1 532 304) wird eine kathodische Schaltungsmöglichkeit für das Aufrauhen von Aluminium beschrieben, wobei der wäßrige Elektrolyt bei einem pH-Wert von 1 bis 5 dann neben Aluminiumsalzen auch noch ein Alkalisalz enthalten muß.

Der Einsatz von Mehrstufenprozessen zur Aufrauhung von Trägermaterial für Flachdruckplatten ist z. B. aus den US-A 2 344 510, 3 929 591 und 4 477 317 (= GB-A 1 582 620), den JP-A 123 204/78, 145 701/78, 16 918/82 und 197 090/83, den DE-A 30 12 135 (= US-A 4 476 006 bzw. GB-A 2 047 274), 30 31 764 (= GB-A 2 058 136) und 30 36 174 (= GB-A 2 060 923) und der EP-A 0 131 926 bekannt.

Nahezu all diese Verfahren beschreiben auch die Notwendigkeit einer Reinigungsbehandlung zwischen mechanischer und elektrochemischer Aufrauhung. Wird diese Behandlung in einem sauren Medium durchgeführt, ist nur mit einem geringen Angriff auf die mechanisch erzeugte Aufrauhstruktur zu rechnen. Die Reinigungswirkung steht im Vordergrund. Im Gegensatz dazu führt eine alkalische Behandlung zu einer deutlichen Veränderung der Oberflä-che.

Die chemische Zwischenbehandlung nach der elektrochemischen zweiten Aufrauhstufe und vor der sich daran anschließenden Anodisierung wird in der US-A 2 344 510 erwähnt und in den JP-A 123 204/78, DE-A 30 12 135 = GB-A 2 047 274 bzw. US-A 4 476 006) und DE-A 30 36 174 (= GB-A 2 060 923) beschrieben. Diese Behandlung wird entweder sauer oder alkalisch vorgenommen, wobei die oben erwähnten Wirkungen erzielt werden. Besonders bei alkalischer Behandlung wird die elektrochemische Aufrauhstruktur durch die Abtragung feiner Porenwände weitgehend eingeebnet, was zwar positive Auswirkungen auf die Wasserführung, aber auch geringere Auflagenleistungen der so hergestellten Druckplatte nach sich zieht.

Der Einsatz einer kathodischen Oberflächenmodifizierung nach einer einstufigen elektrochemischen Aufrauhung ist aus der DE-A 32 22 967 (= US-A 4 482 444) bekannt. Diese Behandlung führt dabei, unter Vermeidung der in dieser Anmeldung beschriebenen Nachteile einer sauren oder alkalischen Beizbehandlung, zu Trägermaterialien mit verbesserter "Wasserführung" und geringerem Abrieb beim Druck, ohne daß die Haftung der Kopierschicht negativ beeinflußt wird.

Aufgabe der vorliegenden Erfindung ist es, ein Verfahren zur Herstellung von Druckplatten-Trägermaterialien vorzuschlagen, wobei eine Vergleichmäßigung der Oberfläche der vorangegangenen Aufrauhung und/oder eine Reduzierung des Wischwasserbedarfs beim Drucken bewirkt wird.

Die Erfindung geht aus von einem Verfahren zur Herstellung von aufgerauhten Trägermaterialien aus Aluminium oder einer seiner Legierungen für Offsetdruckplatten, umfassend die Behandlungsstufen

I) mechanische Aufrauhung des Materials
II) Zwischenbehandlung
III) elektrochemische Aufrauhung in einem säurehaltigen Elektrolyten
IV) Zwischenbehandlung
V) anodische Oxidation der Oberfläche

Das erfindungsgemäße Verfahren ist dadurch gekennzeichnet, daß die Zwischenbehandlung in den Stufen II und/oder IV elektrochemisch durchgeführt wird, wobei das aufgerauhte Blech der vorangehenden Stufe als Kathode geschaltet ist und in einem wäßrigen Elektrolyten eines pH-Wertes von 0 bis 11, der mindestens ein wasserlösliches Salz in einer Konzentration von 3 g/l bis zur Sättigungsgrenze und/oder eine Säure in einer Konzentration von 0,5 bis 50 g/l enthält, durch Anlegen eines Gleichstroms von 3 bis 100 A/dm$^2$ - bei einer Temperatur von 15 bis 90° C während 5 bis 90 sec - ein Materialabtrag von 0,1 bis 10 g/m$^2$ erzeugt wird.

Überraschenderweise führt die erfindungsgemäße kathodische Behandlung nach der mechanischen Aufrauhung zu einer unerwarteten Vergleichmäßigung des elektrochemischen Angriffs in der nachfolgenden Stufe. Die Vergleichmäßigung macht sich bei der Verwendung von Wechselstrom, insbesondere aber bei Verwendung von Gleichstrom bemerkbar.

Nach der elektrochemischen zweiten Aufrauhstufe angewendet, bewirkt die erfindungsgemäße kathodische Modifizierung eine Reduzierung des Wasserbedarfs beim Drucken, ohne daß mit Schichten verschiedener chemischer Herkunft Einbußen in der Auflagenstabilität zu verzeichnen sind. Deshalb wird in einer bevorzugten Ausführungsform der vorliegenden Erfindung sowohl nach der mechanischen als auch nach der elektrochemischen Aufrauhstufe die erfindungsgemäße kathodische Modifizierung der Oberfläche durchgeführt.

Das Verfahren kann auch so durchgeführt werden, daß in einer der Stufen II oder IV eine rein saure oder alkalische Zwischenbehandlung durchgeführt wird, wobei eine solche in Stufe II bevorzugt ist.

In bevorzugten Ausführungsformen weist der Elektrolyt einen pH-Wert von 3 bis 9 auf und enthält mindestens ein wasserlösliches Salz in einer Konzentration von 10 bis 250 g/l. Die Verfahrensbedingungen werden zweckmäßig so gewählt, daß die elektrochemische Modifizierung mit Gleichstrom einer Stromdichte von 3 bis 100 A/dm$^2$, insbesondere von 10 bis 80 A/dm$^2$, bei einer Temperatur von 15 bis 90° C, insbesondere von 20 bis 40° C, und während 5 bis 90 sec, insbesondere 10 bis 60 sec, durchgeführt wird; die entsprechende Spannung liegt bei 5 bis 60 V, insbesondere bei 10 bis 40 V.

Bei Anwendung der erfindungsgemäßen kathodischen Modifizierung in Stufe II ist die bevorzugte Abtragsrate, die leicht und einfach über die angelegte Spannung bzw. Stromdichte zu steuern ist, abhängig von der Art der Aufrauhung in Stufe I. Wird in Stufe I zur mechanischen Aufrauhung eine Strukturierung mit Drahtbürsten vorgenommen, so sind Abtragswerte in der Stufe II zwischen 1 und 10 g/m$^2$ vorteilhaft. Während bei niedrigen Abtragswerten bis 3 g/m$^2$ nach der anschließenden elektrochemischen Aufrauhung die Struktur der Oberfläche eher dem in der DE-A 33 050 67 (= ZA-A 84/0821) beschriebenen Typ ähnelt, entsteht bei höheren Abtragswerten in Stufe II eine stärkerwerdende Wellenstruktur, die dann in Stufe III gleichmäßig, ohne irgendwelche lokale Bevorzugungen, von einer feinen elektrochemischen Aufrauhung überzogen werden kann.

Wird in Stufe I das Aluminiumblech durch Naßbürstung vorstrukturiert, reicht eine Einstellung von Abtragswerten zwischen 0,5 und 3 g/m$^2$ in Stufe II schon aus, um einen gleichmäßigen Stromangriff in Stufe III zu gewährleisten.

Bei mechanischer Aufrauhung mittels Sandstrahlen in Stufe I wirken sich hohe Abtragswerte in Stufe II zwischen 6 und 10 g/m$^2$ günstig auf die Wasserführung des so hergestellten Trägermaterials aus.

Im Falle der Anwendung der erfindungsgemäßen kathodischen Zwischenbehandlung in Stufe IV können Abtragswerte zwischen 0,1 und 0,5 g/m$^2$ bereits zu gewissen Oberflächenverbesserungen führen. Sie sind aber im allgemeinen geringer wirksam. Abtragswerte über 5 g/m$^2$ können unter Umständen bereits zu hoch sein, dies gilt insbesondere dann, wenn die vorherige Aufrauhung eher flach, d. h. mit relativ geringen Rauhtiefen, ausgeführt wurde. Das Verfahren kann diskontinuierlich durchgeführt werden, bevorzugt wird es jedoch in einer modernen Bandanlage kontinuierlich betrieben.

Für den wäßrigen Elektrolyten im erfindungsgemäßen kathodischen Modifizierungsverfahren sind prinzipiell alle wasserlöslichen Salze geeignet, die die Leitfähigkeit von Wasser ausreichend erhöhen und deren Kationen unter den angewandten Bedingungen nicht mit dem als Kathode geschalteten Aluminium so in Wechselwirkung treten, daß sich die Redoxprodukte dort abscheiden. Zur Einstellung einer praxisgerechten Leitfähigkeit werden bevorzugt Alkali-, Erdalkali- oder Aluminiumsalze von Halogenwasserstoffsäuren, sowie der Sauerstoffsäuren von Halogenen, Kohlenstoff, Bor, Stickstoff, Phosphor und Schwefel oder der fluorhaltigen Säuren von Bor, Silicium, Phosphor und Schwefel allein oder in Kombination miteinander verwendet. Dazu gehören insbesondere die Na-, K- oder Mg-Salze der Chlorwasserstoffsäure, Chlorsäure, Salpetersäure, Schwefelsäure, Phosphorsäure, Fluoroborsäure oder Fluorokieselsäure, besonders bevorzugt jedoch die Chloride oder Nitrate. Als Elektrolyt werden vorzugsweise die wäßrigen Lösungen der oben angeführten Salze eingesetzt. Zur Erzielung besonderer Effekte können die Elektrolytlösungen auch die den Salzen entsprechenden Säuren oder Gemische der angegebenen Salze und Säuren enthalten.

Aus produktionstechnischen, ökonomischen und ökologischen Gesichtspunkten werden im Elektrolyten bevorzugt solche Salze verwendet, die in niedriger Konzentration eine gute Leitfähigkeit bewirken, und deren wäßrige Lösungen bereits einen pH-Wert in der Nähe des Neutralpunkts besitzen.

Es kann angenommen werden, daß durch das erfindungsgemäße Verfahren in Stufe IV die Porenwände der durch die vorherige elektrochemische Aufrauhung entstandenen Poren (Zellen) teilweise abgetragen werden und sich am Boden der Zellen Mikroporen bilden; durch diese Beeinflussung der Topographie dürfte eine weniger zerklüftete Oberfläche entstehen. Die Struktur der Oberfläche ist deutlich von einer solchen zu unterscheiden, die durch einstufige Aufrauhung in einem wäßrigen Elektrolyten erzeugt wird, der einen pH-Wert im Neutralbereich aufweist. Der Vorgang der kathodischen Modifizierung von bereits elektrochemisch aufgerauhten Aluminiumoberflächen wird möglicherweise in erster Linie von den elektrischen Bedingungen (Stromdichte bzw. Spannung) in Verbindung mit der Behandlungsdauer (geflossene Ladungsmenge) bestimmt. Alle anderen einstellbaren Verfahrensparameter wie Temperatur, Art des Salzes oder Elektrolytkonzentration wirken sich unter dieser Voraussetzung über die Beeinflussung der elektrischen Leitfähigkeit nur indirekt aus.

Das erfindungsgemäße kathodische Modifizierungsverfahren in einer der Stufen II oder IV führt im Vergleich mit anderen bisher bekanntgewordenen Verfahren zur Herstellung von Trägermaterialien für lithographische Druckplatten zu folgenden Vorteilen:

<u>Verfahrenstechnisch:</u>

- Durch die Anwendung des erfindungsgemäßen Verfahrens in Stufe II ist die primäre Grobstruktur - erzeugt durch Drahtbürsten, Naßbürsten, Sandstrahlen oder andere mechanische Strukturierungsmethoden - in einer Vielzahl von feinen Nuancierungen auf die nachfolgenden Prozeßstufen und die letztendlichen Anwendungseigenschaften abstimmbar. Eine derartige Feinabstufung ist bei den bekannten chemischen Zwischenbehandlungsmethoden nicht erzielbar.
- Die Feinabstufung des Angriffs wird ähnlich vorteilhaft in Stufe IV des Verfahrens eingesetzt.
- Besonders günstig wirkt sich die erfindungsgemäße Modifizierung in Stufe II und Stufe IV in Kombination mit einem anodischen Gleichstromprozeß in Stufe III aus.
- Durch die möglichst weitgehende Neutralität (bezogen auf seinen pH-Wert) des Elektrolyten ist der unkontrollierbare, rein chemische Angriff auf das Aluminium vermutlich vernachlässigbar klein, so daß der modifizierende Abtrag in weiten Temperaturbereichen im wesentlichen über die elektrischen Parameter und die Behandlungszeit gesteuert werden kann. Dadurch eröffnet sich die Möglichkeit, Trägermaterialien für verschiedene Anwendungsbereiche gezielt und ohne großen Aufwand zu modifizieren.
- Da das im wäßrigen Elektrolyten eingesetzte Salz im wesentlichen nur zur Leitfähigkeitserhöhung des Wassers benötigt und während der Behandlung nicht verbraucht wird, kann das Bad sehr lange Zeit ohne irgendwelche Zudosierungen oder Reinigungsoperationen verwendet werden, d. h. es hat eine lange Standzeit.

Anwendungstechnisch:

- Die hellere Trägeroberfläche führt nach dem Entwikkeln zu einem verbesserten Kontrast zwischen Bild- und Nichtbildbereichen.
- Die vergleichmäßigte Aufrauhstruktur ohne größere Vertiefungen bewirkt eine exaktere Steuerung der Belichtung und eine verbesserte Auflösung der strahlungsempfindlichen Schicht auf den Druckplatten.
- Die weniger tiefe Oberflächenrauhigkeit führt zu einem geringeren Feuchtwasserbedarf beim Drucken und zu erhöhter Abriebfestigkeit der Oberfläche.
- Die Oberfläche des Trägermaterials ist ohne große Verfahrensänderungen auf die Anforderungen verschiedener Einsatzgebiete im Druck einstellbar.

Als Metallbasis für das band-, folien- oder plattenförmige Material wird Aluminium oder eine seiner Legierungen verwendet. Darunter sind bevorzugt:

- "Reinaluminium" (DIN-Werkstoff Nr. 3.0255), d. h. bestehend aus ≥ 99,5 % Al und den folgenden zulässigen Beimengungen von (maximale Summe von 0,5 %) 0,3 % Si, 0,4 % Fe, 0,03 % Ti, 0,02 % Cu, 0,07 % Zn und 0,03 % sonstigem, oder
- "Al-Legierung 3003" (vergleichbar mit DIN-Werkstoff Nr. 3.0515), d. h. bestehend aus ≥ 98,5 % Al, den Legierungsbestandteilen 0 bis 0,3 % Mg und 0,8 bis 1,5 % Mn und den folgenden zulässigen Beimengungen von 0,5 % Si, 0,5 % Fe, 0,2 % Ti, 0,2 % Zn, 0,1 % Cu und 0,15 % sonstigem

zu verstehen.

Die mechanische Aufrauhung in Stufe I wird nach bekannten Methoden durchgeführt. Bevorzugt wird im erfindungsgemäßen Prozeß die Aufrauhung mittels einer rotierenden Bürstwalze aus Draht vorgenommen. Besonders bevorzugt ist das Aufrauhverfahren mittels rotierender Nylonbürsten unter Verwendung einer wäßrigen Schleifmittelsuspension.

Die elektrochemische Aufrauhung in Stufe III kann nach einem der üblichen Verfahren mit Wechselstrom in einem wäßrigen, HCl und/oder $HNO_3$ enthaltenden Elektrolyten oder unter anodischer Schaltung des Bandes mittels Gleichstrom durchgeführt werden. Daneben sind z. B. in Stufe III auch noch die folgenden Prozeßvariationen möglich:

- die Aufrauhung von Aluminium in verdünnter, wäßriger HCl-Lösung unter Zusatz von weiteren Säuren wie Chromsäure oder Phosphorsäure nach der DE-B 23 27 764 (= US-A 3 887 447) oder unter Verwendung von Korrosionsinhibitoren wie Aminen, Aldehyden, Amiden, Harnstoff oder nichtionischen Tensiden nach der DE-B 22 18 471,
- die Aufrauhung von Aluminium in verdünnter, wäßriger HCl- oder $HNO_3$-Lösung mit speziellen Stromformen, wie einem Wechselstrom mit größerer Anoden- als Kathodenamplitude der Stromstärke nach der DE-B 26 50 762 (= US-A 4 087 341),
- die Aufrauhung von Aluminium in verdünnter, wäßriger HCl- oder $HNO_3$-Lösung unter Zusatz von Borsäure oder Boraten nach der DE-B 21 49 899,
- die Aufrauhung von Aluminium in einer neutralen, wäßrigen Salzlösung mit Wechselstrom oder anodisch geschaltet mit einer verhältnismäßig hohen Salzkonzentration nach der DE-A 25 37 724, oder

- die Aufrauhung von Aluminium in einer sauren, wäßrigen Aluminiumsalzlösung mit Wechselstrom oder anodisch geschaltet mit einer verhältnismäßig hohen Salzkonzentration nach der DE-A 25 37 725.

Im allgemeinen liegen die Verfahrensparameter in der Aufrauhstufe, insbesondere bei kontinuierlicher Verfahrensführung, in folgenden Bereichen: die Temperatur des Elektrolyten zwischen 20 und 60° C, die Wirkstoff- (Säure-, Salz-)Konzentration zwischen 5 und 100 g/l (bei Salzen auch höher), die Stromdichte zwischen 15 und 130 A/dm², die Verweilzeit zwischen 10 und 100 sec und die Elektrolytströmungsgeschwindigkeit an der Oberfläche des zu behandelnden Werkstücks zwischen 5 und 100 cm/sec; als Stromart wird meistens Wechselstrom eingesetzt, es sind jedoch auch modifizierte Stromarten wie Wechselstrom mit unterschiedlichen Amplituden der Stromstärke für den Anoden- und Kathodenstrom möglich.

In der nachgeschalteten Verfahrensstufe (V) wird das Material anodisch oxidiert, um beispielsweise den Abrieb und die Haftungseigenschaften der Oberfläche des Trägermaterials weiter zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden. Es wird beispielsweise auf folgende Standardmethoden für den Einsatz von $H_2SO_4$ enthaltenden wäßrigen Elektrolyten für die anodische Oxidation von Aluminium hingewiesen (siehe dazu z.B. M.Schenk, Werkstoff Aluminium und seine anodische Oxydation, Francke Verlag - Bern, 1948, Seite 760; Praktische Galvanotechnik, Eugen G. Leuze Verlag - Saulgau, 1970, Seite 395 ff. und Seiten 518/519; W. Hübner und C. T. Speiser, Die Praxis der anodischen Oxidation des Aluminiums, Aluminium Verlag - Düsseldorf, 1977, 3. Auflage, Seiten 137 ff):

- Das Gleichstrom-Schwefelsäure-Verfahren, bei dem in einem wäßrigen Elektrolyten aus üblicherweise ca. 230 g $H_2SO_4$ pro 1 l Lösung bei 10° bis 22°C und einer Stromdichte von 0,5 bis 2,5 A/dm² während 10 bis 60 min anodisch oxidiert wird. Die Schwefelsäurekonzentration in der wäßrigen Elektrolytlösung kann dabei auch bis auf 8 bis 10 Gew.-% $H_2SO_4$ (ca. 100 g $H_2SO_4$/l verringert oder auch auf 30 Gew.-% (365 g $H_2SO_4$/l) und mehr erhöht werden.
- Die "Hartanodisierung" wird mit einem wäßrigen, $H_2SO_4$ enthaltenden Elektrolyten einer Konzentration von 166 g $H_2SO_4$/l (oder ca. 230 g $H_2SO_4$/l) bei einer Betriebstemperatur von 0° bis 5°C, bei einer Stromdichte von 2 bis 3 A/dm², einer steigenden Spannung von etwa 25 bis 30 V zu Beginn und etwa 40 bis 100 V gegen Ende der Behandlung und während 30 bis 200 min durchgeführt.

Neben den im vorhergehenden Absatz bereits genannten Verfahren zur anodischen Oxidation von Druckplatten-Trägermaterialien können beispielsweise noch die folgenden Verfahren zum Einsatz kommen: die anodische Oxidation von Aluminium in einem wäßrigen $H_2SO_4$ enthaltenden Elektrolyten, dessen $Al^{3+}$-Ionengehalt auf Werte von mehr als 12 g/l eingestellt wird gemäß der DE-A 28 11 396 (= US-A 4 211 619), in einem wäßrigen, $H_2SO_4$ und $H_3PO_4$ enthaltenden Elektrolyten gemäß der DE-A 27 07 810 (= US-A 4 049 504) oder in einem wäßrigen, $H_2SO_4$, $H_3PO_4$ und $Al^{3+}$-Ionen enthaltenden Elektrolyten gemäß der DE-A 28 36 803 (= US-A 4 229 266). Zur anodischen Oxidation wird bevorzugt Gleichstrom verwendet, es kann jedoch auch Wechselstrom oder eine Kombination dieser Stromarten (z. B. Gleichstrom mit überlagertem Wechselstrom) eingesetzt werden. Die Schichtgewichte an Aluminiumoxid bewegen sich im Bereich von 1 bis 10 g/m², entsprechend einer Schichtdicke von etwa 0,3 bis 3,0 μm.

Dem erfindungsgemäßen Verfahren mit der Stufe V einer anodischen Oxidation des Druckplatten-Trägermaterials aus Aluminium können auch eine oder mehrere Nachbehandlungsstufen nachgeschaltet werden. Dabei wird unter Nachbehandeln in einer Stufe VI insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung gemäß der DE-A 16 21 478 (= GB-A 1 230 447), eine Tauchbehandlung in einer wäßrigen Alkalisilikat-Lösung gemäß der DE-B 14 71 707 (= US-A 3 181 461) oder eine elektrochemische Behandlung (Anodisierung) in einer wäßrigen Alkalisilikat-Lösung gemäß der DE-A 25 32 769 (= US-A 3 902 976). Diese Nachbehandlungsstufen dienen insbesondere dazu, die bereits für viele Anwendungsgebiete ausreichende Hydrophilie der Aluminiumoxidschicht noch zusätzlich zu steigern, wobei die übrigen bekannten Eigenschaften dieser Schicht mindestens erhalten bleiben.

Eine weitere Lösung der gestellten Aufgabe ist die Verwendung des erfindungsgemäß in Stufe I mechanisch, in Stufe III elektrochemisch aufgerauhten, in den Stufen II und/oder IV kathodisch modifizierten, in Stufe V anodisch oxidierten und in Stufe VI hydrophilierend nachbehandelten Materials bei der Herstellung von eine strahlungsempfindliche Schicht tragenden Druckplatten. Dabei wird entweder beim Hersteller von vorsensibilisierten Druckplatten oder beim Beschichten eines Trägermaterials beim Verbraucher das Trägermaterial mit einer der folgenden strahlungsempfindlichen Massen beschichtet:

Als strahlungsempfindliche Schichten sind grundsätzlich alle Schichten geeignet, die nach dem Bestrahlen (Belichten), gegebenenfalls mit einer nachfolgenden Entwicklung und/oder Fixierung eine bildmäßige Fläche liefern, von der gedruckt werden kann.

Neben den auf vielen Gebieten verwendeten Silberhalogenide enthaltenden Schichten sind auch verschiedene andere bekannt, wie sie z.B. in "Light-Sensitive Systems" von Jaromir Kosar, John Wiley & Sons Verlag, New York 1965 beschrieben werden: die Chromate und Dichromate enthaltenden Kolloidschichten (Kosar, Kapitel 2); die ungesättigte Verbindungen enthaltenden Schichten, in denen diese Verbindungen beim Belichten isomerisiert, umgelagert, cyclisiert oder vernetzt werden (Kosar, Kapitel 4); die photopolymerisierbare Verbindungen enthaltenden Schichten, in denen Monomere oder Präpolymere gegebenenfalls mittels eines Initiators beim Belichten polymerisieren (Kosar, Kapitel 5); und die o-Diazochinone wie Naphthochinondiazide, p-Diazochinone oder Diazoniumsalz-Kondensate enthaltenden Schichten (Kosar, Kapitel 7). Zu den geeigneten Schichten zählen auch die elektrophotographischen Schichten, d. h. solche die einen anorganischen oder organischen Photoleiter enthalten. Außer den lichtempfindlichen Substanzen können diese Schichten selbstverständlich noch andere Bestandteile wie z. B. Harze, Farbstoffe oder Weichmacher enthalten. Insbesondere können die folgenden lichtempfindlichen Massen oder Verbindungen bei der Beschichtung der nach dem erfindungsgemäßen Verfahren hergestellten Trägermaterialien eingesetzt werden:

positiv-arbeitende o-Chinondiazid-, bevorzugt o-Naphthochinondiazid-Verbindungen, die beispielsweise in den DE-C 854 90, 865 109, 879 203, 894 959, 938 233, 1 109 521, 1 144 705, 1 118 606, 1 120 273 und 1 124 817 beschrieben werden;

negativ-arbeitende Kondensationsprodukte aus aromatischen Diazoniumsalzen und Verbindungen mit aktiven Carbonylgruppen, bevorzugt Kondensationsprodukte aus Diphenylamindiazoniumsalzen und Formaldehyd, die beispielsweise in den DE-A 596 731, 1 138 399, 1 138 400, 1 138 401, 1 142 871, 1 154 123, den US-A 2 679 498 und 3 050 502 und der GB-A 712 606 beschrieben werden;

negativ-arbeitende Mischkondensationsprodukte aromatischer Diazoniumverbindungen, beispielsweise nach der DE-A 2 024 244;

positiv-arbeitende Schichten nach der DE-A 26 108 42, der DE-A 27 18 254 oder der DE-OS 29 28 636, die eine bei Bestrahlung Säure abspaltende Verbindung, eine monomere oder polymere Verbindung, die mindestens eine durch Säure abspaltbare C-O-C-Gruppe aufweist (z.B. eine Orthocarbonsäureestergruppe oder eine Carbonsäureamidacetalgruppe) und gegebenenfalls ein Bindemittel enthalten;

negativ-arbeitende Schichten aus photopolymerisierbaren Monomeren, Photoinitiatoren, Bindemitteln und gegebenenfalls weiteren Zusätzen. Als Monomere werden dabei beispielsweise Acryl- und Methacrylsäureester oder Umsetzungsprodukte von Diisocyanaten mit Partialestern mehrwertiger Alkohole eingesetzt, wie es beispielsweise in den US-A 2 760 863 und 3 060 023 und den DE-A 2 064 079 und 2 361 041 beschrieben wird;

negativ-arbeitende Schichten gemäß der DE-A 30 36 077, die als lichtempfindliche Verbindung ein Diazoniumsalz-Polykondensationsprodukt oder eine organische Azidoverbindung und als Bindemittel ein hochmolekulares Polymeres mit seitenständigen Alkenylsulfonyl- oder Cycloalkenylsulfonylurethan-Gruppen enthalten.

Es können auch photohalbleitende Schichten, wie sie z.B. in den DE-A 11 17 391, 15 22 497, 15 72 312, 23 22 046 und 23 22 047 beschrieben werden, auf die erfindungsgemäß hergestellten Trägermaterialien aufgebracht werden, wodurch hochlichtempfindliche, elektrophotographisch-arbeitende Druckplatten entstehen.

Prozentangaben in den folgenden Beispielen sind auf das Gewicht bezogen, Gew.-Teile stehen zu Vol.-Teilen im gleichen Verhältnis wie kg zu l. Bei der Beurteilung der nach dem erfindungsgemäßen Verfahren hergestellten Trägermaterialien werden die folgenden Standardmethoden herangezogen:

Bestimmung des Feuchtwasserverbrauchs

Die Antragsmenge des Feuchtwassers wird durch eine Anzeigevorrichtung in einem Feuchtwerk der Firma Dahlgren bestimmt. Sie ist kein absolutes Maß für den Feuchtwasserverbrauch, es können aber die Angaben dieser Vorrichtung in Skalenteilen von verschiedenen Druckdurchgängen miteinander verglichen werden (relative Maße).

Bestimmung der Abriebfestigkeit

Zur Definition des Abriebverhaltens werden die aus nach dem erfindungsgemäßen Verfahren kathodisch modifizierten Trägermaterialien hergestellten Druckformen in einer Druckmaschine neben aus entsprechend aufgerauhten und anodisierten Trägermaterialien ohne diese Modifizierungsstufe hergestellten Druckformen gedruckt. In bestimmten Abständen werden dann beide Platten bezüglich Haftung der Schicht und glänzender Stellen (Anzeichen für Abrieb) in den Nichtbildbereichen verglichen.

Bestimmung des Abtrags

Der Abtrag, der durch die kathodische Modifizierung am Aluminiumträger eintritt, wird gravimetrisch bestimmt. Dazu werden aufgerauhte Aluminiumbleche im Format 100 × 100 mm vor der kathodischen Behandlung gewogen. Nach der erfindungsgemäßen Behandlung sowie Spülen und Trocknen der Proben wird durch Rückwiegen der Abtrag bestimmt.

Bestimmung der Rauhtiefe

Die Rauhtiefe wird nach DIN 4768 in der Fassung vom Oktober 1970 ermittelt, die Rauhtiefe $R_z$ ist dann das arithmetische Mittel aus den Einzelrauhtiefen fünf aneinandergrenzender Einzelmeßstrecken. Die Einzelrauhtiefe ist definiert als der Abstand zweier Parallelen zur mittleren Linie, die innerhalb der Einzelmeßstrekken das Rauheitsprofil am höchsten bzw. am tiefsten Punkt berühren. Die Einzelmeßstrecke ist der fünfte Teil der senkrecht auf die mittlere Linie projizierten Länge des unmittelbar zur Auswertung benutzten Teils des Rauheitsprofils. Die mittlere Linie ist die Linie parallel zur allgemeinen Richtung des Rauheitsprofils von der Form des geometrisch-idealen Profils, die das Rauheitsprofil so teilt, daß die Summe der werkstofferfüllten Flächen über ihr und der werkstofffreien Flächen unter ihr gleich sind.

Die Erfindung wird im folgenden anhand ausgewählter, bevorzugter Beispiele dargestellt, ohne jedoch hierauf beschränkt zu sein.

Beispiele 1 bis 43

Soweit nicht besonders darauf hingewiesen ist, wird in den nachfolgenden Beispielen - zur Demonstration der besonderen Effekte der kathodischen Modifizierung in den Behandlungsstufen II und IV - das erfindungsgemäße Verfahren in den Stufen I, III, V und VI immer unter den folgenden Bedingungen durchgeführt:

Stufe I : Drahtbürstung (D) mit einer daraus resultie-renden Rauhtiefe $R_z$ von längs der Walzrichtung 5,0 $\mu$m und quer der Walzrichtung 6,6 $\mu$m

Naßbürstung (N) mit einer daraus resultierenden Rauhtiefe $R_z$ von längs der Walzrichtung 5,4 $\mu$m und quer der Walzrichtung 5,7 $\mu$m

Sandstrahlung (S) mit einer daraus resultierenden Rauhtiefe $R_z$ von längs der Walzrichtung 7,9 $\mu$m und quer der Walzrichtung 8,1 $\mu$m

Stufe III: Die elektrochemische Aufrauhung wird bei allen Beispielen in einer wäßrigen Lösung eines Gehalts von 20 g/l $HNO_3$ und 50 g/l $Al(NO_3)_3 \cdot 9 H_2O$ bei einer Temperatur von 40 bis 45 °C unter Einwirkung von Wechselstrom einer Stromdichte von 20 A/dm$^2$ in einer Zeit von 10 sec unter starker Badumwälzung durchgeführt.

Stufe V : Der Anodisierungsprozeß wird in allen Beispielen in einem wäßrigen, schwefelsäurehaltigen Elektrolyten - entsprechend den in der DE-A 28 11 396 beschriebenen Bedingungen - durchgeführt. Das Oxidschichtgewicht beträgt 3,0 g/m$^2$.

Stufe VI : Die bevorzugte hydrophilierende Nachbehandlung des anodisierten Materials wird in in allen Beispielen in einer wäßrigen Lösung von 5 g/l Polyvinylphosphonsäure bei einer Temperatur von 50 ° C und einer Einwirkzeit von 20 sec durchgeführt.

Bei allen in den Beispielen durchgeführten Verfahrensvarianten schließt sich an jeden der Behandlungsschritte eine Spülung der Oberfläche mit vollentsalztem Wasser an.

Die in den Stufen II und IV verwendete Arbeitstemperatur beträgt in allen Fällen 30 bis 35 ° C.

## Tabelle I

Kathodische Zwischenbehandlung nach der mechanischen Aufrauhung
(Stufe I)

| Bei-spiel | Elektrolyt | Konz. (g/l) | pH-Wert | Span-nung (V) | Strom-dichte $(A/dm^2)$ | Zeit (sec) | mech. Auf-rauh. | Abtrag $(g/m^2)$ |
|---|---|---|---|---|---|---|---|---|
| 1 | NaNO$_3$ | 5 | 6,4 | 40 | 5 | 90 | D | 0,50 |
| 2 | NaNO$_3$ | 10 | 6,6 | 60 | 17 | 30 | N | 1,27 |
| 3 | NaNO$_3$ | 20 | 6,8 | 25 | 10 | 60 | D | 1,18 |
| 4 | NaNO$_3$ | 50 | 6,9 | 30 | 38 | 20 | N | 1,69 |
| 5 | NaNO$_3$ | 50 | 6,9 | 50 | 80 | 10 | D | 2,88 |
| 6 | NaNO$_3$ | 100 | 7,3 | 40 | 65 | 20 | N | 3,96 |
| 7 | NaNO$_3$ | 250 | 8,2 | 20 | 45 | 30 | D | 4,10 |
| 8 | NaNO$_3$/HNO$_3$ | 20/ 5 | 1,2 | 10 | 12 | 30 | N | 1,66 |
| 9 | NaNO$_3$/HNO$_3$ | 50/10 | 0,9 | 10 | 41 | 30 | N | 4,12 |
| 10 | NaCl | 5 | 6,3 | 50 | 11 | 30 | N | 0,44 |
| 11 | NaCl | 10 | 6,9 | 40 | 16 | 30 | D | 0,75 |
| 12 | NaCl | 20 | 7,2 | 25 | 19 | 30 | N | 1,32 |
| 13 | NaCl | 20 | 7,2 | 30 | 24 | 30 | D | 1,68 |
| 14 | NaCl | 20 | 7,2 | 50 | 48 | 30 | N | 4,25 |
| 15 | NaCl | 50 | 7,6 | 40 | 68 | 30 | S | 5,97 |
| 16 | NaCl | 100 | 8,1 | 30 | 70 | 30 | N | 6,26 |
| 17 | NaCl | 250 | 8,5 | 20 | 80 | 30 | S | 7,43 |
| 18 | NaCl/HCl | 50/10 | 0,5 | 10 | 45 | 30 | N | 4,32 |
| 19 | NaCl/HCl | 50/ 5 | 0,9 | 10 | 13 | 30 | N | 1,79 |
| 20 | NaClO$_3$ | 50 | 7,4 | 30 | 20 | 30 | N | 1,28 |
| 21 | NaHSO$_4$ | 50 | 6,5 | 20 | 16 | 30 | N | 0,91 |
| 22 | NaH$_2$PO$_4$ | 50 | 7,6 | 20 | 10 | 30 | N | 0,62 |
| 23 | Na$_2$B$_4$O$_7$ | 50 | 9,3 | 50 | 15 | 30 | N | 0,64 |
| 24 | NaBF$_4$ | 50 | 3,8 | 30 | 22 | 30 | N | 2,43 |
| 25 | NaSiF$_4$ | 20 | 3,5 | 40 | 8 | 60 | N | 0,75 |

## Tabelle II

**Kathodische Modifizierung nach der elektrochemischen Aufrauhung**
**(Stufe III)**

| Bei-spiel | Elektrolyt | Konz. (g/l) | pH-Wert | Span-nung (V) | Strom-dichte (A/dm$^2$) | Zeit (sec) | Abtrag (g/m$^2$) |
|---|---|---|---|---|---|---|---|
| 26 | NaNO$_3$ | 5 | 6,4 | 60 | 9 | 60 | 0,87 |
| 27 | NaNO$_3$ | 10 | 6,6 | 60 | 17 | 30 | 1,32 |
| 28 | NaNO$_3$ | 20 | 6,8 | 25 | 10 | 60 | 1,35 |
| 29 | NaNO$_3$ | 20 | 6,8 | 40 | 18 | 30 | 1,28 |
| 30 | NaNO$_3$ | 50 | 6,9 | 30 | 38 | 20 | 1,85 |
| 31 | NaNO$_3$ | 50 | 6,9 | 50 | 80 | 10 | 2,89 |
| 32 | NaNO$_3$ | 100 | 7,3 | 30 | 45 | 20 | 2,51 |
| 33 | NaNO$_3$ | 100 | 7,3 | 40 | 65 | 20 | 3,87 |
| 34 | NaNO$_3$ | 250 | 8,2 | 15 | 30 | 20 | 1,26 |
| 35 | NaCl | 250 | 8,2 | 20 | 45 | 30 | 4,22 |
| 36 | NaCl | 10 | 6,9 | 40 | 16 | 30 | 0,83 |
| 37 | NaCl | 20 | 7,2 | 25 | 19 | 30 | 1,42 |
| 38 | NaCl | 20 | 7,2 | 50 | 48 | 30 | 4,36 |
| 39 | NaCl | 50 | 7,6 | 20 | 25 | 30 | 1,18 |
| 40 | NaCl | 50 | 7,6 | 50 | 100 | 10 | 3,85 |
| 41 | NaCl | 100 | 8,1 | 15 | 30 | 30 | 1,93 |
| 42 | NaCl | 100 | 8,1 | 20 | 44 | 30 | 3,74 |
| 43 | NaCl | 250 | 8,5 | 20 | 80 | 10 | 3,11 |

Beispiel 44

Ein gemäß Beispiel 6 in der Stufe II und gemäß Beispiel 33 in der Stufe IV zwischenbehandeltes Aluminiumblech wird mit folgender Lösung beschichtet:

| | |
|---|---|
| 6,00 Gew.-Teile | Kresol-Formaldehyd-Novolak (mit Erweichungsbereich 105 bis 120° C nach DIN 53 181), |
| 1,10 Gew.-Teile | des 4-(2-Phenyl-prop-2-yl)-phenyl esters der Naphtochinon-(1,2)-diazid-(2)-sulfonsäure-(4), |
| 0,81 Gew.-Teile | Polyvinylbutyral, |

0,75 Gew.-Teile Naphthochinon-(1,2)-diazid-(2)-sulfochlorid-(4),

0,08 Gew.-Teile Kristallviolett,

91,36 Gew.-Teile Lösemittelgemisch aus 4 Vol.-Teilen Ethylenglykolmonomethylether, 5 Vol.-Teilen Tetrahydrofuran und 1 Vol.-Teil Essigsäurebutylester.

Das auf dem Träger aufgebrachte Gewicht der strahlungsempfindlichen Schicht beträgt etwa 3 $g/m^2$. Die Platte wird unter einer Vorlage mit einer 5-kW-Metallhalogenid-Lampe belichtet und mit folgender Lösung entwickelt:

5,3 Gew.-Teile Natriummetasilikat $\cdot$ 9 $H_2O$

3,4 Gew.-Teile Trinatriumphosphat $\cdot$ 12 $H_2O$

0,3 Gew.-Teile Natriumdihydrogenphosphat (wasserfrei)

91,0 Gew.-Teile Wasser.

Von der so hergestellten Druckform lassen sich mehr als 150.000 Drucke von guter Qualität herstellen. Das Druckverhalten ist sehr gut. Auch bei sparsamer Feuchtwasserzuführung neigt die Platte nicht zur Farbannahme in den Nichtbildstellen ("Tonen"). Die Druckform verbraucht etwa 10 bis 15 % weniger Feuchtwasser als eine Vergleichsdruckform, deren Trägermaterial zwischen Stufe III und Stufe V nicht kathodisch abtragend behandelt wird, aber sonst gleichwertig aufgebaut ist. Während bei beiden Druckformen die Reproduktionsschicht noch gut erhalten ist, zeigt die Folie des Vergleichsbeispiels nach etwa 90.000 bis 110.000 Drucken glänzende Flächen in den Nichtbildbereichen, was auf mechanischen Abrieb hinweist. Demgegenüber zeigt die erfindungsgemäß hergestellte Platte auch nach 150.000 Drucken noch keine Anzeichen von Verschleiß des Trägermaterials.

Beispiel 45

Ein gemäß Beispiel 19 in der Stufe II und gemäß Beispiel 42 in der Stufe IV zwischenbehandeltes Aluminiumträgermaterial wird mit folgender Lösung beschichtet:

0,70 Gew.-Teile des Polykondensationsproduktes aus 1 Mol 3-Methoxydiphenylamin-4-diazoniumsulfat und 1 Mol 4,4′-Bis-methoxymethyl-diphenylether, ausgefällt als Mesitylensulfonat,

3,40 Gew.-Teile $H_3PO_4$ (85 %ig)

3,00 Gew.-Teile eines modifizierten Epoxidharzes, erhalten durch Umsetzen von 50 Gew.-Teilen eines Epoxidharzes mit einem Molgewicht unterhalb 1000 und 12,8 Gew.-Teilen Benzoesäure in Ethylenglykolmonomethylether in Gegenwart von Benzyltrimethylammoniumhydroxid,

0,44 Gew.-Teile feingemahlenes Heliogenblau G (C.I. 74 100),

62,00 Vol.-Teile Ethylenglykolmonomethylether,

30,60 Vol.-Teile Tetrahydrofuran und

8,00 Vol.-Teile Essigsäurebutylester.

Nach dem Belichten durch eine Vorlage wird mit einer Lösung von

2,80 Gew.-Teilen $Na_2SO_4$ $\cdot$ 10 $H_2O$,

2,80 Gew.-Teilen $MgSO_4$ $\cdot$ 7 $H_2O$,

0,90 Gew.-Teilen $H_3PO_4$ (85 %ig),

0,08 Gew.-Teilen $H_3PO_3$,

1,60 Gew.-Teilen nichtionischem Tensid,

10,00 Gew.-Teilen Benzylalkohol,

20,00 Gew.-Teilen n-Propanol und

60,00 Gew.-Teilen Wasser

entwickelt.

Die derart hergestellte Druckform liefert in einer Bogenoffsetdruckmaschine mehr als 150.000 Drucke von guter Qualität und zeigt auch nach Ablaufen der Schicht keinerlei Spuren einer mechanischen Beschädigung der Trägeroberfläche in den Nichtbildbereichen.

Im Vergleich zu einer Druckform, bei der während der Herstellung des Trägermaterials auf die Zwischenbehandlung in Stufe IV verzichtet wurde, benötigt das Trägermaterial mit einer Zwischenbehandlung gemäß Beispiel 42 25 % weniger Feuchtmittel.

Ein Trägermaterial, bei dessen Herstellung auf die erfindungsgemäßen Zwischenbehandlungen in den Stufen II und IV verzichtet wurde, zeigt eine dunkelgraue, streifige Oberfläche und ist somit für den praktischen Einsatz nicht geeignet.

**Patentansprüche**

1. Verfahren zur Herstellung von aufgerauhten Trägermaterialien aus Aluminium oder einer seiner Legierungen für Flachdruckplatten, umfassend die Behandlungsstufen

I) mechanische Aufrauhung des Materials

II) Zwischenbehandlung

III) elektrochemische Aufrauhung in einem säurehaltigen Elektrolyten

IV) Zwischenbehandlung

V) anodische Oxidation der Oberfläche

dadurch gekennzeichnet, daß die Zwischenbehandlung in den Stufen II und/oder IV elektrochemisch durchgeführt wird, wobei man den aufgerauhten Träger der vorangehenden Stufe als Kathode schaltet und den wäßrigen Elektrolyten auf einen pH-Wert von 0 bis 11 einstellt, wobei der Elektrolyt mindestens ein wasserlösliches Salz in einer Konzentration von 3 g/l bis zur Sättigungsgrenze und/oder eine Säure in einer Konzentration von 0,5 bis 50 g/l, wobei man Gleichstrom von 3 bis 100 A/dm$^2$ und eine Temperatur von 15 bis 90 °C während 5 bis 90 sec anwendet, wobei man die Parameter derart abstimmt, daß ein Materialabtrag von 0,1 bis 10 g/m$^2$ erzeugt wird.

2. Verfahren nach Anspruch 1, dadurch gekennzeichnet, daß man den pH-Wert des Elektrolyten in den Stufen II und/oder IV auf 1 bis 11 einstellt.

3. Verfahren nach den Ansprüchen 1 und 2, dadurch gekennzeichnet, daß man den pH-Wert des Elektrolyten in den Stufen II und/oder IV auf 3 bis 9 einstellt.

4. Verfahren nach den Ansprüchen 1 und 2, dadurch gekennzeichnet, daß man den pH-Wert des Elektrolyten in den Stufen II und/oder IV auf 1 bis 5 einstellt.

5. Verfahren nach den Ansprüchen 1 bis 3, dadurch gekennzeichnet, daß der Elektrolyt mindestens ein wasserlösliches Salz in einer Konzentration von 10 bis 250 g/l enthält.

6. Verfahren nach den Ansprüchen 1 bis 5, dadurch gekennzeichnet, daß der Elektrolyt mindestens eine Säure in einer Konzentration von 1 bis 20 g/l enthält.

7. Verfahren nach einem der Ansprüche 1 bis 6, dadurch gekennzeichnet, daß die elektrochemische Zwischenbehandlung der Stufen II und/oder IV mit Gleichstrom einer Stromdichte von 10 bis 80 A/dm$^2$ bei einer Temperatur von 20 bis 40 °C während 10 bis 60 sec durchgeführt wird.

8. Verfahren nach einem der Ansprüche 1 bis 7, dadurch gekennzeichnet, daß der Elektrolyt der Stufen II und/oder IV als wasserlösliches Salz mindestens ein Alkali-, Erdalkali- oder Aluminiumsalz der Halogenwasserstoffsäuren, der Sauerstoffsäuren von Halogenen, Kohlenstoff, Bor, Stickstoff, Phosphor oder Schwefel oder der fluorhaltigen Säuren von Bor, Silicium, Phosphor oder Schwefel enthält.

9. Verfahren nach den Ansprüchen 1 bis 8, dadurch gekennzeichnet, daß der Elektrolyt der Stufen II und/oder IV als Säure Halogenwasserstoffsäure oder Sauerstoffsäuren von Halogenen, Kohlenstoff, Bor, Stickstoff, Phosphor oder Schwefel enthält.

10. Verfahren nach Anspruch 1, dadurch gekennzeichnet, daß man die Zwischenbehandlung in einer der Stufen II oder IV chemisch in einem sauren oder alkalischen Medium durchführt.

11. Verfahren nach den Ansprüchen 1 und 10, dadurch gekennzeichnet, daß man die Zwischenbehandlung in der Stufe II chemisch in einem sauren oder alkalischen Medium durchführt.

12. Verfahren nach einem der Ansprüche 1 bis 10, dadurch gekennzeichnet, daß man die mechanische Aufrauhung in Stufe I mittels Drahtbürstung, Naßbürstung oder Sandstrahlung durchführt.

13. Verfahren nach einem der Ansprüche 1 bis 12, dadurch gekennzeichnet, daß man in Stufe III die Materialien in einem wäßrigen, Salzsäure und/oder Salpetersäure enthaltenden Elektrolyten mit Wechselstrom elektrochemisch aufrauht.

14. Verfahren nach einem der Ansprüche 1 bis 12, dadurch gekennzeichnet, daß man in Stufe III die Materialien in einem wäßrigen, Salpetersäure enthaltenden Elektrolyten mit Gleichstrom elektrochemisch aufrauht.

**15.** Verfahren nach einem der Ansprüche 1 bis 14, dadurch gekennzeichnet, daß man die Druckplatten-Trägermaterialien in Stufe V in einem wäßrigen, Schwefel-und/oder Phosphorsäure enthaltenden Elektrolyten mit Gleichstrom anodisch oxidiert.

**16.** Verfahren nach einem der Ansprüche 1 bis 15, dadurch gekennzeichnet, daß man die anodisch oxidierten Druckplatten-Trägermaterialien hydrophilierend nachbehandelt.

**17.** Verwendung der nach einem der Ansprüche 1 bis 16 hergestellten Trägermaterialien für eine strahlungsempfindliche Schicht tragende Offsetdruckplatte.

**Claims**

**1.** Process for the manufacture of grained support materials of aluminum or an aluminum alloy for use in lithographic printing plates, which comprises the following treatment stages:

I) mechanical graining of the material,
II) intermediate treatment,
III) electrochemical graining in an acid-containing electrolyte,
IV) intermediate treatment,
V) anodic oxidation of the surface,

wherein the intermediate treatment in stages II and/or IV is an electrochemical treatment, in which the grained support of the preceding stage is made the cathode and the aqueous electrolyte is adjusted to a pH ranging from 0 to 11, the electrolyte containing at least one water-soluble salt in a concentration from 3 g/l up to the saturation limit and/or an acid in a concentration from 0.5 to 50 g/l, direct current from 3 to 100 A/dm$^2$ and a temperature from 15° to 90° C being applied for a duration from 5 to 90 seconds and the parameters being adjusted in such a way that a removal of material from 0.1 to 10 g/m$^2$ is produced.

**2.** A process as claimed in claim 1, wherein the pH of the electrolyte used in stages II and/or IV is adjusted to a value from 1 to 11.

**3.** A process as claimed in claims 1 and 2, wherein the pH of the electrolyte used in stages II and/or IV is adjusted to a value from 3 to 9.

**4.** A process as claimed in claims 1 and 2, wherein the pH of the electrolyte used in stages II and/or IV is adjusted to a value from 1 to 5.

**5.** A process as claimed in claims 1 to 3, wherein the electrolyte contains at least one water-soluble salt in a concentration from 10 to 250 g/l.

**6.** A process as claimed in claims 1 to 5, wherein the electrolyte contains at least one acid in a concentration from 1 to 20 g/l.

**7.** A process as claimed in any of claims 1 to 6, wherein the electrochemical intermediate treatment of stages II and/or IV is carried out using a direct current at a current density from 10 to 80 A/dm$^2$, at a temperature from 20° to 40° C and for a duration from 10 to 60 seconds.

**8.** A process as claimed in any of claims 1 to 7, wherein the electrolyte used in stages II and/or IV contains, as the water-soluble salt, at least one alkali metal salt, alkaline earth metal salt or aluminum salt of halohydric acids, of the oxo-acids of halogens, carbon, boron, nitrogen, phosphorus or sulfur or of the fluorine-containing aids of boron, silicon, phosphorus or sulfur.

**9.** A process as claimed in claims 1 to 8, wherein the electrolyte used in stages II and/or IV contains, as the acid, a halohydric acid or an oxo-acid of a halogen, of carbon, boron, nitrogen, phosphorus or sulfur.

**10.** A process as claimed in claim 1, wherein the intermediate treatment in one of the stages II and IV is a chemical treatment in an acidic or alkaline medium.

**11.** A process as claimed in claims 1 and 10, wherein the intermediate treatment in stage II is a chemical treatment in an acidic or alkaline medium.

**12.** A process as claimed in any of claims 1 to 10, wherein mechanical graining in stage I comprises wire brushing, slurry brushing or sandblasting.

**13.** A process as claimed in any of claims 1 to 12, wherein, in stage III, the materials are electrochemically grained with an alternating current in an aqueous electrolyte containing hydrochloric acid and/or nitric acid.

**14.** A process as claimed in any of claims 1 to 12, wherein, in stage III, the materials are electrochemically grained with a direct current, in an aqueous electrolyte containing nitric acid.

**15.** A process as claimed in any of claims 1 to 14, wherein the support materials for printing plates, in stage V, are anodically oxidized with a direct current, in an aqueous electrolyte containing sulfuric acid and/or phosphoric acid.

**16.** A process as claimed in any of claims 1 to 15, wherein the anodically oxidized support materials for printing plates are subjected to a hydrophilizing post-treatment.

**17.** Use of the support materials manufactured according to any of claims 1 to 16 for the preparation of offset printing plates which carry a radiation-sensitive layer.

**Revendications**

**1.** Procédé pour la production de matériaux de support grainés en aluminium ou en l'un de ses alliages, pour plaques d'impression à plat, comprenant les étapes de traitement
I) grainage mécanique du matériau
II) traitement intermédiaire
III) grainage électrochimique dans un électrolyte contenant un acide
IV) traitement intermédiaire
V) oxydation anodique de la surface,
caractérisé en ce que l'on effectue électrochimiquement le traitement intermédiaire dans les étapes II et/ou IV, en connectant en tant que cathode le support grainé de l'étape précédente et en ajustant l'électrolyte aqueux à un pH de 0 à 11, l'électrolyte contenant au moins un sel soluble dans l'eau, à une concentration allant de 3 g/l à la limite de saturation, et/ou un acide à une concentration allant de 0,5 à 50 g/l, en appliquant pendant 5 à 90 secondes un courant continu de 3 à 100 A/dm$^2$ et une température de 15 à 90°C, en ajustant les paramètres de manière à produire un enlèvement de matière allant de 0,1 à 10 g/m$^2$.

**2.** Procédé selon la revendication 1, caractérisé en ce que l'on ajuste le pH de l'électrolyte, dans les étapes II et/ou IV, à 1-11.

**3.** Procédé selon les revendications 1 et 2, caractérisé en ce que l'on ajuste le pH de l'électrolyte, dans les étapes II et/ou IV, à 3-9.

**4.** Procédé selon les revendications 1 et 2, caractérisé en ce que l'on ajuste le pH de l'électrolyte, dans les étapes II et/ou IV, à 1-5.

**5.** Procédé selon les revendications 1 à 3, caractérisé en ce que l'électrolyte contient au moins un sel soluble dans l'eau, à une concentration allant de 10 à 250 g/l.

**6.** Procédé selon les revendications 1 à 5, caractérisé en ce que l'électrolyte contient au moins un acide à une concentration allant de 1 à 20 g/l.

**7.** Procédé selon l'une des revendications 1 à 6, caractérisé en ce que le traitement intermédiaire

14

électrochimique des étapes II et/ou IV est effectué pendant 10 à 60 secondes, à une température de 20 à 40°C, avec du courant continu à une densité de courant de 10 à 80 A/dm$^2$.

8.  Procédé selon l'une des revendications 1 à 7, caractérisé en ce que l'électrolyte des étapes II et/ou IV contient, en tant que sel soluble dans l'eau, au moins un sel alcalin, alcalino-terreux ou d'aluminium des hydracides halogénés, des acides oxygénés d'halogènes, du carbone, du bore, de l'azote, du phosphore ou du soufre, ou des acides fluorés du bore, du silicium, du phosphore ou du soufre.

9.  Procédé selon les revendications 1 à 8, caractérisé en ce que l'electrolyte des étapes II et/ou IV contient en tant qu'acide un hydracide halogéné ou des acides oxygénés d'halogènes, du carbone, du bore, de l'azote, du phosphore ou du soufre.

10. Procédé selon la revendication 1, caractérisé en ce que l'on effectue le traitement intermédiaire, dans l'une des étapes II ou IV, chimiquement dans un milieu acide ou alcalin.

11. Procédé selon les revendications 1 et 10, caractérisé en ce que l'on effectue le traitement intermédiaire, dans l'étape II, chimiquement dans un milieu acide ou alcalin.

12. Procédé selon l'une des revendications 1 à 10, caractérisé en ce que l'on effectue le grainage mécanique dans l'étape I par brossage à la brosse métallique, brossage humide ou projection de sable.

13. Procédé selon l'une des revendications 1 à 12, caractérisé en ce que, dans l'étape III, on soumet les matériaux à un grainage électrochimique avec du courant alternatif, dans un électrolyte aqueux contenant de l'acide chlorhydrique et/ou de l'acide nitrique.

14. Procédé selon l'une des revendications 1 à 12, caractérisé en ce que, dans l'étape III, on soumet les matériaux à un grainage électrochimique avec du courant continu, dans un électrolyte aqueux contenant de l'acide nitrique.

15. Procédé selon l'une des revendications 1 à 14, caractérisé en ce que, dans l'étape V, on oxyde par anodisation les matériaux de support pour plaques d'impression, avec du courant continu, dans un électrolyte aqueux contenant de l'acide sulfurique et/ou de l'acide phosphorique.

16. Procédé selon l'une des revendications 1 à 15, caractérisé en ce que l'on soumet à un post-traitement d'hydrophilisation les matériaux de support pour plaques d'impression, oxydés par anodisation.

17. Utilisation des matériaux de support produits selon l'une des revendications 1 à 16, pour une plaque d'impression offset portant une couche sensible aux radiations.